# EUROPEAN PATENT APPLICATION

(11) **EP 4 739 071 A1**
(43) Date of publication of application: **06.05.2026**
(21) Application number: 25209778.7
(22) Date of filing: 20.10.2025
(51) Int. Cl.: H10W 70/685, H10W 70/692, C03C 15/02, H05K 1/03, H10W 70/05

(54) **SUBSTRATE AND MANUFACTURING METHOD FOR THE SAME**

(30) Priority: 29.10.2024 US 202463713078 P; 31.10.2024 US 202463714156 P
(71) Applicant: Absolics Inc., Covington, GA 30014 (US)
(72) Inventor: KIM, Sungjin, Covington, Georgia, 30014 (US); KIM, Jincheol, 18469 Hwaseong-si, Gyeonggi-do (KR)
(74) Representative: BCKIP Part mbB

(57) **Abstract**

A substrate according to the present disclosure comprises a glass core having an upper surface. A maximum height roughness (Rmax) value of the upper surface of the glass core is 3 nm to 7 nm. A surface energy of the upper surface of the glass core is 50 mN/m to 63 mN/m. In such a case, an insulating layer having improved peel resistance may be implemented on the glass core, and electrical reliability of the substrate may be further improved.

## Description

### TECHNICAL FIELD

The present disclosure relates to a substrate and a manufacturing method for the same.

### BACKGROUND

In manufacturing electronic components, implementing circuits on a semiconductor wafer is referred to as a front-end (FE) process, and assembling the wafer into a state usable in an actual product is referred to as a back-end (BE) process, and a packaging process is included in this back-end process.

Among the four core technologies of the semiconductor industry that have enabled the rapid development of electronic products in recent years are semiconductor technology, semiconductor packaging technology, manufacturing process technology, and software technology. Semiconductor technology has developed in various forms such as a line width at micro or sub-nano levels, more than ten million cells, high-speed operation, and a large amount of heat dissipation; however, technology to perfectly package the same has not been sufficiently supported. Accordingly, the electrical performance of a semiconductor may be determined by packaging technology and the electrical connection according thereto rather than by the performance of the semiconductor technology itself.

As materials for a packaging substrate, ceramic or resin is applied. In the case of a ceramic substrate, it is not easy to mount a high-performance, high-frequency semiconductor device due to a high resistance value or a high dielectric constant. In the case of a resin substrate, a high-performance, high-frequency semiconductor device can be relatively mounted; however, there is a limit to reduction of the wiring pitch.

Recently, studies have been conducted in which silicon or glass is applied as a high-end packaging substrate. A through-hole is formed in a silicon or glass substrate, and a conductive material is applied to the through-hole, whereby the wiring length between a device and a motherboard can be shortened and excellent electrical characteristics can be obtained.

### SUMMARY

According to one embodiment of the present specification, a substrate includes a glass core having an upper surface.

A maximum height roughness (Rmax) value of the upper surface of the glass core is 3 nm to 7 nm.

A surface energy of the upper surface of the glass core is 50 mN/m to 63 mN/m.

A ratio of a contact angle of the upper surface of the glass core with respect to water to a contact angle of the upper surface of the glass core with respect to diiodomethane may be 0.75 or greater.

A contact angle of the upper surface of the glass core with respect to water may be 40° to 55°.

An arithmetic average roughness (Ra) value of the upper surface of the glass core may be 0.3 nm to 0.5 nm.

A root-mean-square roughness (Rq) value of the upper surface of the glass core may be 0.4 nm to 1 nm.

The substrate may further include an insulating layer disposed on the glass core.

The insulating layer may include an epoxy-based resin.

A peel strength of the insulating layer with respect to the upper surface of the glass core, measured by a 90° peeling test, may be 25 N/cm² or greater.

A shear strength of the insulating layer with respect to the upper surface of the glass core may be 40 N/cm² or greater.

The substrate may be for semiconductor packaging use.

The substrate may include a first redistribution layer disposed on the glass core.

The first redistribution layer may include a conductive layer and an insulating layer surrounding at least a portion of the conductive layer.

The first redistribution layer may include an upper surface.

A waviness of the upper surface of the first redistribution layer may be 0.7 µm or less.

The conductive layer may include a first conductive layer formed in contact with the upper surface of the glass core.

A ratio of an area of the upper surface of the glass core occupied by the first conductive layer to an entire area of the upper surface of the glass core may be 80% or less.

A thickness of the first conductive layer may be 10 µm to 50 µm.

A modulus of elasticity of the insulating layer measured at 23 °C may be 8 GPa or less.

A coefficient of thermal expansion of the insulating layer may be 60 ppm/°C or less.

The insulating layer may include a filler.

The insulating layer may include 65 wt% or more of the filler.

A thickness of the glass core may be 200 µm to 2,000 µm.

A ratio of a thickness of the first redistribution layer to a thickness of the glass core may be 0.1 to 1.

Another embodiment of the substrate according to the present specification includes a glass core and a first redistribution layer disposed on the glass core.

The first redistribution layer includes a conductive layer and an insulating layer surrounding at least a portion of the conductive layer.

The first redistribution layer includes an upper surface.

A waviness of the upper surface of the first redistribution layer is 0.7 µm or less.

The waviness of the upper surface of the first redistribution layer may be 0.3 µm or less.

The glass core may include an upper surface.

The conductive layer may include a first conductive layer formed in contact with the upper surface of the glass core.

A ratio of an area of the upper surface of the glass core occupied by the first conductive layer to an entire area of the upper surface of the glass core may be 80% or less.

A thickness of the first conductive layer may be 10 µm to 50 µm.

A modulus of elasticity of the insulating layer measured at 23 °C may be 8 GPa or less.

A coefficient of thermal expansion of the insulating layer may be 60 ppm/°C or less.

The insulating layer may include a filler.

The insulating layer may include 65 wt% or more of the filler.

A thickness of the glass core may be 200 µm to 2,000 µm.

A ratio of a thickness of the first redistribution layer to a thickness of the glass core may be 0.1 to 1.

The substrate may be a packaging substrate.

A method of manufacturing a substrate according to another embodiment of the present specification includes a preparation step of preparing a base glass plate and a roughening step of forming a glass core by roughening an upper surface of the base glass plate.

The glass core has an upper surface.

A maximum height roughness (Rmax) value of the upper surface of the glass core is 3 nm to 7 nm.

A surface energy of the upper surface of the glass core is 50 mN/m to 63 mN/m.

### Brief Description of the Drawings

FIG. 1 is a plan view illustrating a substrate according to one embodiment of the present specification.
FIG. 2 is a plan view illustrating a substrate according to another embodiment of the present specification.
FIG. 3 is a plan view illustrating a substrate according to yet another embodiment of the present specification.
FIG. 4 is a plan view illustrating a substrate according to still another embodiment of the present specification.

### Detailed Description of the Invention

Hereinafter, exemplary embodiments will be described in detail with reference to the accompanying drawings so that those skilled in the art to which the present disclosure pertains may easily carry out the present disclosure. However, the present disclosure may be embodied in various different forms and is not limited to the embodiments described herein.

In the present specification, the term "combination thereof" included in a Markush-type expression means a mixture or combination of one or more components selected from the group consisting of the components described in the Markush-type expression, and means that one or more selected from the group consisting of the components are included.

In the present specification, the terms "first," "second," or "A," "B," and the like are used to distinguish the same terms from each other. In addition, unless the context clearly indicates otherwise, singular expressions include plural expressions.

In the present specification, "~ based" may mean that a compound includes the compound corresponding to "~" and/or a derivative of "~."

In the present specification, the meaning that B is disposed on A may mean that B is disposed directly in contact with A or that another layer is interposed therebetween while B is disposed on A, and shall not be interpreted as being limited to B being disposed in contact with the surface of A.

In the present specification, the meaning that B is connected to A may mean that A and B are directly connected or connected through another component, and unless otherwise stated, shall not be interpreted as being limited to A and B being directly connected.

In the present specification, unless otherwise described, singular expressions shall be interpreted as including singular or plural meanings as understood from the context.

In the drawings of the present specification, the shape, relative size, and angle of each component are illustrative and may be exaggerated for explanation purposes, and the scope of rights shall not be interpreted as being limited to the drawings.

In the present specification, that A and B are adjacent may mean that A and B are positioned in contact or close to each other without being in contact, and unless otherwise stated, shall not be interpreted as being limited to A and B being positioned in contact.

In the present specification, "high frequency" means a frequency of about 1 GHz to about 300 GHz. Specifically, it may mean a frequency of about 1 GHz to about 30 GHz, and may mean a frequency of about 1 GHz to about 15 GHz.

In the present specification, unless otherwise described, the term "fine line" means a line having a width of 5 µm or less, and for example, means a line having a width of 1 µm to 4 µm or less.

Hereinafter, the present disclosure will be described in detail.

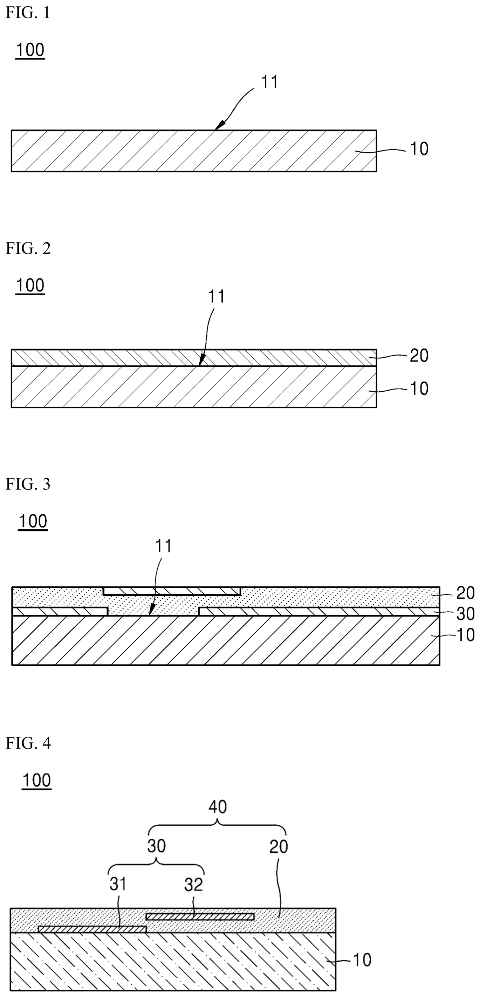

FIG. 1 is a plan view illustrating a substrate according to one embodiment of the present specification. Referring to FIG. 1, a substrate of the present disclosure will be described.

### Glass Core

A substrate (100) according to one embodiment of the present disclosure includes a glass core (10) having an upper surface (11).

The glass core (10) serves as a support in the substrate (100). The glass core (10) may be made of glass.

The present disclosure may apply a glass material core to suppress the generation of parasitic elements and power loss in the core caused by the application of high-frequency power.

As materials of the glass core (10), for example, alkali borosilicate, non-alkali borosilicate, non-alkali alkaline-earth borosilicate, and the like may be applied, and any plate glass material applicable as an electronic component may be applied.

A thickness of the glass core (10) may be 50 µm or more. The thickness may be 100 µm or more. The thickness may be 200 µm or more. The thickness may be 250 µm or more. The thickness may be 400 µm or more. The thickness may be 500 µm or more. The thickness may be 3,000 µm or less. The thickness may be 2,000 µm or less. The thickness may be 1,000 µm or less. When the glass core (10) having such a thickness is applied, it may have excellent applicability as a core for semiconductor packaging.

The glass core (10) may include a through-via (not shown) penetrating in a thickness direction of the glass core (10).

The through-via includes an inner space (not shown) and a via inner surface (not shown) surrounding the inner space. The inner space means an empty space, and the via inner surface means a surface of the glass core (10) formed inside the through-via.

The through-via may have a diameter varying in a thickness direction of the glass core (10). The through-via may have a substantially uniform diameter in the thickness direction of the glass core (10).

The present disclosure may control both roughness characteristics and surface energy characteristics of the upper surface (11) of the glass core. Through this, the affinity of the upper surface (11) of the glass core with respect to the insulating layer may be improved. In addition, the contact area between the insulating layer and the glass core (10) may be further enlarged, and an anchor effect may be induced between the insulating layer and the glass core (10). The upper surface of the glass core having such characteristics may further improve the peel resistance of the insulating layer.

A maximum height roughness (Rmax) value of the upper surface (11) of the glass core may be 3 nm to 7 nm. The Rmax value may be 3.2 nm or more. The Rmax value may be 5 nm or less. The Rmax value may be 4 nm or less.

A surface energy of the upper surface (11) of the glass core may be 50 mN/m to 63 mN/m. The surface energy may be 52 mN/m or more. The surface energy may be 54 mN/m or more. The surface energy may be 60 mN/m or less.

In this case, a substrate capable of implementing an insulating layer having excellent bonding strength to the upper surface (11) of the glass core may be provided.

The Rmax value of the upper surface (11) of the glass core is measured by an Atomic Force Microscope (AFM) according to the maximum height roughness measurement method specified in ISO 4287:1997.

The surface energy of the upper surface (11) of the glass core is calculated from measurement values after measuring contact angles of the upper surface (11) of the glass core with respect to water and diiodomethane, respectively, using a surface analyzer. When measuring contact angles of droplets of water or diiodomethane dropped on the upper surface (11) of the glass core, if the contact angle values measured at the left and right sides of the droplet are different from each other, an average of the two values is taken as the contact angle of the upper surface (11) of the glass core. For example, a Mobile Surface Analyzer of KRÜSS may be applied as the surface analyzer.

The present disclosure may control the ratio of the contact angle of the upper surface (11) of the glass core with respect to diiodomethane to the contact angle of the upper surface (11) of the glass core with respect to water within a predetermined range. By adjusting the ratio, the upper surface (11) of the glass core, of which surface characteristics are controlled, may exhibit more excellent affinity for the insulating layer to which a resin containing a hydrophobic residue is applied.

A ratio of a contact angle of the upper surface (11) of the glass core with respect to water to a contact angle of the upper surface (11) of the glass core with respect to diiodomethane may be 0.75 or greater. The ratio may be 0.8 or greater. The ratio may be 0.85 or greater. The ratio may be 0.9 or greater. The ratio may be 1.5 or less. The ratio may be 1.3 or less. The ratio may be 1.1 or less. In this case, even when an insulating layer having hydrophobic residue is applied on the upper surface (11) of the glass core, a substrate exhibiting excellent durability may be implemented.

A contact angle of the upper surface (11) of the glass core with respect to water may be 40° to 55°. The contact angle may be 43° or more. The contact angle may be 46° or more. The contact angle may be 52° or less.

A contact angle of the upper surface (11) of the glass core with respect to diiodomethane may be 40° to 55°. The contact angle may be 43° or more. The contact angle may be 46° or more. The contact angle may be 52° or less.

In this case, the upper surface (11) of the glass core may exhibit excellent bonding strength even with an insulating layer including hydrophobic residue.

An arithmetic average roughness (Ra) value of the upper surface (11) of the glass core may be 0.3 nm to 0.5 nm. The Ra value may be 0.32 nm or more. The Ra value may be 0.34 nm or more. The Ra value may be 0.4 nm or less. When the upper surface (11) of the glass core has such roughness characteristics, it may assist in forming a stable fine adhesion structure between the upper surface (11) of the glass core and the insulating layer.

A root-mean-square roughness (Rq) value of the upper surface (11) of the glass core may be 0.4 nm to 1 nm. The Rq value may be 0.41 nm or more. The Rq value may be 0.42 nm or more. The Rq value may be 0.8 nm or less. The Rq value may be 0.6 nm or less. The Rq value may be 0.5 nm or less. When the upper surface (11) of the glass core is controlled to have such characteristics, the unevenness positioned on the upper surface (11) of the glass core may exhibit reduced influence on fine pattern formation to a certain level or lower while still showing excellent bonding strength with the insulating layer.

The Ra value and the Rq value of the upper surface (11) of the glass core are measured by an Atomic Force Microscope (AFM) according to the measurement method specified in ISO 4287:1997.

### Insulating layer

FIG. 2 is a plan view illustrating a substrate according to another embodiment of the present specification. Referring to FIG. 2, a substrate of the present disclosure will be described.

The substrate (100) includes a glass core (10) having an upper surface (11). The detailed configuration of the substrate (100) is applied as described in FIG. 1 above. Hereinafter, the differences will be mainly described.

The substrate (100) of the present disclosure may include an insulating layer (20) disposed on the glass core (10). The insulating layer (20) may be disposed in contact with at least a portion of the upper surface (11) of the glass core.

The insulating layer (20) provides insulation to a desired region in the substrate (100) and may stably support a conductive layer.

The insulating layer (20) may include an epoxy-based resin. The epoxy-based resin may have mechanical properties and insulation suitable for being applied as an insulating layer of a glass substrate after curing.

The insulating layer (20) may include an epoxy-based resin and a filler. The filler may help the insulating layer (20) to have mechanical properties and thermal expansion characteristics desired in the present disclosure.

The insulating layer (20) may be formed by laminating an uncured or semi-cured insulating film on the upper surface (11) of the glass core and then curing the film. The insulating layer (20) may also be formed by coating an insulating layer-forming composition on the upper surface (11) of the glass core and then curing the composition.

The insulating layer (20) may be formed, for example, using a build-up layer material such as an Ajinomoto Build-up Film (ABF) of Ajinomoto Co., or an undercoat material, but is not limited thereto.

A peel strength of the insulating layer (20) with respect to the upper surface (11) of the glass core, measured by a 90° peeling test, may be 25 N/cm² or greater. The peel strength may be 27 N/cm² or greater. The peel strength may be 29 N/cm² or greater. The peel strength may be 32 N/cm² or greater. The peel strength may be 34 N/cm² or greater. The peel strength may be 50 N/cm² or less.

A shear strength of the insulating layer (20) with respect to the upper surface (11) of the glass core may be 40 N/cm² or greater. The shear strength may be 45 N/cm² or greater. The shear strength may be 50 N/cm² or greater. The shear strength may be 55 N/cm² or greater. The shear strength may be 80 N/cm² or less.

In this case, at least a portion of the insulating layer (20) may be stably prevented from being detached from the upper surface (11) of the glass core during a manufacturing or transfer process of the substrate (100).

The peel strength may be measured in a region of 1 cm by 1 cm in the substrate (100) by using a Universal Testing Machine (UTM) equipped with a 500 N load cell. When peeling the insulating layer (20), the insulating layer (20) is peeled from the upper surface (11) of the glass core at an angle of 90°, and a peeling speed is set to 10 mm/min. During the peel strength measurement, an ambient temperature is set to 23 °C, and an ambient humidity is set to 50 RH%.

The shear strength may be measured in a region of 1 cm by 1 cm in the substrate (100) by using a Universal Testing Machine (UTM) equipped with a 1 kN load cell. A load is applied to the insulating layer (20) in an in-plane direction of the substrate (100) at a speed of 5 mm/min in the region until the insulating layer (20) is separated, and a maximum load at that time is taken as the shear strength. During the shear strength measurement, an ambient temperature is set to 23 °C, and an ambient humidity is set to 50 RH%.

For example, a 5969 UTM of Instron Co. may be applied as the Universal Testing Machine.

The present disclosure may control a modulus of elasticity of the insulating layer (20) within a predetermined range. Through this, even when the insulating layer (20) thermally expands or contracts during the manufacturing process of the substrate (100), excessive external force may not act on the glass core (10).

The modulus of elasticity of the insulating layer (20) is measured in a pull mode at 23 °C by a Universal Testing Machine (UTM). During the measurement, a tensile speed is set to 1 mm/min, and an average of N = 5 conditions is taken.

A modulus of elasticity of the insulating layer (20) measured at 23 °C may be 8 GPa or less. The modulus of elasticity may be 7 GPa or less. The modulus of elasticity may be 6 GPa or less. The modulus of elasticity may be 5 GPa or less. The modulus of elasticity may be 4 GPa or less. The modulus of elasticity may be 1 GPa or more. In this case, stress inside the glass core (10) due to volume change of the insulating layer (20) may be reduced to a certain level or lower.

A coefficient of thermal expansion of the insulating layer (20) may be 60 ppm/°C or less. The coefficient of thermal expansion may be 50 ppm/°C or less. The coefficient of thermal expansion may be 40 ppm/°C or less. The coefficient of thermal expansion may be 30 ppm/°C or less. The coefficient of thermal expansion may be 20 ppm/°C or less. The coefficient of thermal expansion may be 5 ppm/°C or more. In this case, a difference in thermal expansion and thermal contraction characteristics between the insulating layer (20) and the glass core (10) may be controlled, thereby suppressing a peeling phenomenon of a first redistribution layer and damage of the glass core (10).

The coefficient of thermal expansion of the insulating layer (20) is measured by a thermomechanical analyzer (TMA) based on JIS-C6481. During the measurement, the tensile method is performed according to IPC-TM650, and a temperature rise rate is applied at 10°C/min. The coefficient of thermal expansion is measured within a range of 25°C to 100°C.

The insulating layer (20) may include an epoxy resin and a filler. The insulating layer (20) may include a cured epoxy resin and a filler.

The epoxy resin may be any one selected from the group consisting of bisphenol-type epoxy resin, novolac-type epoxy resin, biphenyl-type epoxy resin, arylalkylene-type epoxy resin, tetraphenylethane-type epoxy resin, naphthalene-type epoxy resin, anthracene-type epoxy resin, phenoxy-type epoxy resin, dicyclopentadiene-type epoxy resin, norbornene-type epoxy resin, and a combination thereof.

The insulating layer (20) may include 10 wt% or more of the epoxy resin. The insulating layer (20) may include 15 wt% or more of the epoxy resin. The insulating layer (20) may include 20 wt% or more of the epoxy resin. The insulating layer (20) may include 35 wt% or less of the epoxy resin. The insulating layer (20) may include 32 wt% or less of the epoxy resin. The insulating layer (20) may include 29 wt% or less of the epoxy resin. The insulating layer (20) may include 25 wt% or less of the epoxy resin.

The insulating layer (20) may include a filler. The filler may include an inorganic filler. The inorganic filler may be any one selected from the group consisting of barium sulfate, silica, talc, clay, magnesium carbonate, calcium carbonate, aluminum oxide, aluminum hydroxide, silicon nitride, aluminum nitride, titanium oxide, and a combination thereof.

An average diameter of the inorganic filler may be 5 µm or less. The average diameter may be 4 µm or less. The average diameter may be 3 µm or less. The average diameter may be 2 µm or less. The average diameter may be 0.5 µm or more.

A maximum diameter of the inorganic filler may be 20 µm or less. The maximum diameter may be 17 µm or less. The maximum diameter may be 15 µm or less. The maximum diameter may be 12 µm or less. The maximum diameter may be 10 µm or less. The maximum diameter may be 5 µm or more.

In this case, it may assist in precisely forming a fine wiring layer on the insulating layer (20), thereby stably securing electrical reliability of the substrate (100).

The filler may further include an organic filler. The organic filler in the insulating layer (20) may have a property of attracting each other through interaction. This property may assist in reducing the degree of thermal expansion of the insulating layer (20) as temperature increases.

The organic filler may have a fine fibrous shape having a diameter of 100 nm or less. The organic filler may include fine cellulose powder. The organic filler may be fine cellulose powder. The fine cellulose powder may be obtained from natural plant fiber raw materials such as wood, hemp, bamboo, and cotton. Specifically, the fine cellulose powder may be obtained by releasing the fine cellulose powder through pulverization treatment, high-temperature and high-pressure steam treatment, acid treatment, and/or oxidation treatment of the natural plant fiber raw material.

The insulating layer (20) may include 65 wt% or more of the filler. The insulating layer (20) may include 68 wt% or more of the filler. The insulating layer (20) may include 71 wt% or more of the filler. The insulating layer (20) may include 75 wt% or more of the filler. The insulating layer (20) may include 90 wt% or less of the filler. In this case, it may assist in imparting relatively low thermal expansion and high flexibility to the insulating layer (20).

The filler may include 1 wt% to 25 wt% of the organic filler. The filler may include 5 wt% or more of the organic filler. The filler may include 10 wt% or more of the organic filler. The filler may include 20 wt% or less of the organic filler. In this case, it may contribute to further alleviating the thermal expansion characteristics of the insulating layer (20).

The insulating layer (20) may further include other additives in addition to the components described above. The additives are not limited as long as they are commonly used in the field of packaging substrates. The additives may include, for example, a curing agent, a colorant, or a defoaming agent.

### Other Components in the Substrate

FIG. 3 is a plan view illustrating a substrate according to another embodiment of the present specification. Referring to FIG. 3, a substrate of the present disclosure will be described.

The substrate (100) includes a glass core (10) having an upper surface (11). The detailed configurations of the substrate (100) are applied as described in FIGS. 1 and 2 above. Hereinafter, the differences will be mainly described.

The substrate (100) may further include a conductive layer (30). The conductive layer (30) may be formed on and/or under the glass core (10) and may serve to transmit signals.

The conductive layer (30) may have a pattern shape. The insulating layer (20) and the conductive layer (30) may be arranged in a mixed manner. The conductive layer (30) may be formed in an embedded form in the insulating layer (20). The conductive layer (30) may be formed as a fine line.

At least a portion of the conductive layer (30) may be formed in contact with the upper surface (11) of the glass core. In this case, the insulating layer (20) may be disposed so as to surround an upper surface and side surfaces of the conductive layer (30) formed in contact with the upper surface (11) of the glass core.

A width of the conductive layer (30) may be 1 µm to 5 µm. The width may be 4.5 µm or less. The width may be 4 µm or less.

A thickness of the conductive layer (30) may be 1 µm to 5 µm. The thickness may be 4.5 µm or less. The thickness may be 4 µm or less.

In this case, a high-density pattern of the conductive layer (30) may be implemented in the substrate (100), and the conductive layer (30) may be assisted in having a stable resistance characteristic under high-frequency current.

The conductive layer (30) may include a seed layer (not shown) and a conductor layer (not shown) disposed on the seed layer.

The seed layer may exhibit a bonding strength of a certain level or more with respect to a bonding target surface (particularly, the upper surface (11) of the glass core). The conductor layer may be stably bonded to the surface of the glass core via the seed layer.

The seed layer may include an element different from a metal element applied to the conductor layer. The seed layer may include a metal element applied to the conductor layer and a metal element different from the metal element applied to the conductor layer. The seed layer may include a first seed layer (not shown) including an element different from the metal element applied to the conductor layer and a second seed layer (not shown) disposed on the first seed layer and including the same element as the metal element applied to the conductor layer. For example, the first seed layer may include a material such as titanium, chromium, or nickel, and the second seed layer may include a material such as copper, nickel, aluminum, gold, or silver.

The seed layer may be formed through a sputtering process. The seed layer may assist the conductor layer to be smoothly formed on the glass core (10) through a plating process.

The present disclosure may form a structure in which the seed layer and the upper surface (11) of the glass core having controlled roughness characteristics are stably engaged with each other by adjusting the thickness of the seed layer.

A thickness of the seed layer may be 50 nm to 1,500 nm. The thickness may be 80 nm or more. The thickness may be 100 nm or more. The thickness may be 150 nm or more. The thickness may be 200 nm or more. The thickness may be 250 nm or more. The thickness may be 300 nm or more. The thickness may be 1,200 nm or less. The thickness may be 1,000 nm or less.

In this case, the seed layer may assist the conductive layer (30) in having excellent bonding strength and may enable the conductive layer (30) to be efficiently formed.

The conductor layer may be formed on the seed layer through a plating process. A conductive material may be applied as a material of the conductor layer. For example, the conductor layer may include at least one selected from copper, nickel, aluminum, gold, or silver.

The conductive layer (30) may include a first conductive layer formed in contact with the upper surface of the glass core (10). The conductive layer (30) may further include a second conductive layer not in contact with the upper surface of the glass core (10).

A ratio of an area of the upper surface of the glass core (10) occupied by the first conductive layer to an entire area of the upper surface of the glass core (10) may be 80% or less.

During the formation process of the insulating layer (20), the glass core (10) and the first conductive layer may be repeatedly exposed to an environment in which the temperature rises above a certain level and then falls. The glass core (10) and the first conductive layer may exhibit different thermal expansion characteristics. When the glass core (10) has relatively high hardness, cracks or other damage may occur in the glass core (10) due to a mismatch in thermal expansion characteristics between the glass core (10) and the first conductive layer.

The present disclosure may stably control stress increase in the substrate (100) resulting from the mismatch in thermal expansion characteristics between the first conductive layer and the glass core (10) by controlling an area ratio of the first conductive layer to the entire upper surface of the glass core (10).

A ratio of an area of the upper surface of the glass core (10) occupied by the first conductive layer to an entire area of the upper surface of the glass core (10) may be 80% or less. The ratio may be 75% or less. The ratio may be 70% or less. The ratio may be 30% or more. In this case, in the substrate (100) after completion of the manufacturing process, an occurrence frequency of cracks in the glass core (10) may be effectively reduced.

A thickness of the first conductive layer may be 10 µm to 50 µm. The thickness may be 15 µm or more. The thickness may be 20 µm or more. The thickness may be 45 µm or less. The thickness may be 40 µm or less. In this case, peeling of at least a portion of the first conductive layer from the upper surface of the glass core (10) due to thermal expansion and contraction of the first conductive layer may be suppressed.

A thickness of the second conductive layer may be equal to or thinner than a thickness of the first conductive layer. The thickness of the second conductive layer may be thinner than the thickness of the first conductive layer. The second conductive layer may have a thinner thickness as it goes upward in the thickness direction of the substrate (100).

A width of the second conductive layer may be equal to or narrower than a width of the first conductive layer. The width of the second conductive layer may be narrower than the width of the first conductive layer. The second conductive layer may have a narrower width as it goes upward in the thickness direction of the substrate (100).

In this case, electrical connection between the substrate (100) and a device may be facilitated.

The substrate (100) may include a first redistribution layer disposed on the glass core (10). The first redistribution layer may electrically connect the substrate (100) and a device or the like.

The first redistribution layer may be disposed in contact with at least a portion of the upper surface of the glass core (10). The first redistribution layer may be disposed in contact with the upper surface of the glass core (10).

The first redistribution layer may include the conductive layer (30) and the insulating layer (20) surrounding at least a portion of the conductive layer (30). The conductive layer (30) and the insulating layer (20) may be the same as those described above.

The first redistribution layer includes an upper surface. A waviness of the upper surface of the first redistribution layer (40) is 0.7 µm or less.

In the case of the substrate (100) having the waviness controlled within a predetermined range as in the present disclosure, excessive deformation of the conductive layer (30) and the glass core (10) caused by curing or thermal shrinkage of the insulating layer (20) may be effectively suppressed. Through this, electrical connections formed within the first redistribution layer or within a through-via may be stably maintained.

The waviness is measured by a surface roughness tester. For example, an M300 model of Mahr may be applied as the surface roughness tester. During the measurement of the waviness, filtering is applied to a surface profile of a measurement target. A Gaussian filter is applied as the filtering condition, and a cut-off length is set to 0.8 mm. During the measurement by the surface roughness tester, a contact pressure is applied at 0.75 mN to 1.0 mN, a measurement speed is applied at 0.1 mm/s to 0.5 mm/s, and a resolution of 0.01 µm is applied.

A waviness of the upper surface of the first redistribution layer may be 0.7 µm or less. The waviness may be 0.6 µm or less. The waviness may be 0.5 µm or less. The waviness may be 0.4 µm or less. The waviness may be 0.3 µm or less. The waviness may be 0.01 µm or more. In this case, the internal stress intensity of the substrate (100) caused by thermal expansion or the like of the insulating layer (20) may be reduced to a certain level or lower.

The present disclosure may control a thickness ratio between the glass core (10) and the first redistribution layer. In this case, damage to the glass core (10) resulting from a difference in thermal expansion characteristics between the glass core (10) and the first redistribution layer may be stably suppressed.

A ratio of a thickness of the first redistribution layer to a thickness of the glass core (10) may be 0.1 to 1. The ratio may be 0.3 or more. The ratio may be 0.8 or less. In this case, it may assist in suppressing a SeWaRe phenomenon, which is a type of damage to the glass core (10).

The first redistribution layer may further include a polyimide layer (not shown) disposed on the insulating layer (20) and the conductive layer (30). The polyimide layer may provide insulation and heat resistance to a desired region in the first redistribution layer. Through this, damage to the insulating layer (20) exposed to a high-temperature atmosphere during the manufacturing process of the substrate (100) may be suppressed.

The polyimide layer is not limited as long as it is commonly used in the field of packaging substrates.

The first redistribution layer may further include a solder resist layer (not shown) disposed on the insulating layer (20) and the conductive layer (30).

The solder resist layer may be disposed on the upper surface of the first redistribution layer. The solder resist layer may provide insulation to a desired region of the upper surface of the first redistribution layer and may protect the conductive layer (30) in the first redistribution layer from external forces.

The solder resist layer is not limited as long as it is commonly used in the field of packaging substrates. The substrate (100) of the present disclosure may further include, as necessary, an upper connection electrode (not shown) disposed on an upper side of the substrate (100) and electrically connecting a device and the conductive layer (30). The upper connection electrode may be directly connected to the device. The upper connection electrode may be connected to the device through a device connection portion such as a solder ball.

The substrate (100) may further include a second redistribution layer (not shown) disposed under the glass core (10).

The second redistribution layer may include a conductive layer and an insulating layer surrounding at least a portion of the conductive layer. The conductive layer and the insulating layer included in the second redistribution layer may be the same as those applied to the first redistribution layer. A description of the conductive layer and the insulating layer included in the second redistribution layer is omitted because it overlaps with the foregoing.

The insulating layer and the conductive layer may be arranged in a mixed manner in the second redistribution layer. The second redistribution layer may be formed such that the conductive layer having a predetermined position and shape is embedded in the insulating layer. The second redistribution layer may be electrically connected to a terminal or a main board positioned at a lower portion of the substrate (100).

A waviness of a lower surface of the second redistribution layer may be 0.7 µm or less.

By simultaneously controlling the waviness of the upper surface of the first redistribution layer and the waviness of the lower surface of the second redistribution layer, it may contribute to suppressing shape deformation of components in the substrate (100). Through this, the electrical reliability of the substrate (100) may be stably maintained.

The method for measuring the waviness is omitted because it overlaps with the above description.

A waviness of an upper surface of the second redistribution layer may be 0.7 µm or less. The waviness may be 0.6 µm or less. The waviness may be 0.5 µm or less. The waviness may be 0.4 µm or less. The waviness may be 0.3 µm or less. The waviness may be 0.01 µm or more. In this case, it may assist in more effectively reducing stress applied to the substrate (100).

A ratio of a thickness of the second redistribution layer to a thickness of the glass core (10) may be 0.1 to 1. The ratio may be 0.3 or more. The ratio may be 0.8 or less.

A ratio of a sum of a thickness of the first redistribution layer and a thickness of the second redistribution layer to a thickness of the glass core (10) may be 0.2 to 2. The ratio may be 0.6 or more. The ratio may be 1.6 or less. In this case, it may contribute to suppressing damage to the glass core (10) during a process of temperature increase and decrease in ambient atmosphere.

The substrate (100) of the present disclosure may further include, as necessary, a lower connection electrode (not shown) disposed at a lower side of the substrate (100) and electrically connecting the conductive layer (30) to a main board. The lower connection electrode may be directly connected to the main board. The lower connection electrode may be connected to the main board through a connection portion such as a bump.

The present disclosure may further include, as necessary, a bump (not shown) disposed at a lower side of the substrate (100). The bump may be disposed in a partial region of a lower surface of the substrate (100) so as to contact a main board or the like.

The substrate (100) may be for use in semiconductor packaging. The substrate (100) may be used for mounting and protecting a semiconductor device and for providing electrical connection between the device and a main board.

### Substrate According to Another Embodiment

FIG. 4 is a plan view illustrating a substrate according to another embodiment of the present specification. Hereinafter, referring to FIG. 4, an embodiment of the present disclosure will be described.

The descriptions regarding the glass core (10), the insulating layer (20), and the conductive layer (30) described in FIGS. 1 to 3 are equally applied to FIG. 4.

A substrate (100) according to another embodiment of the present disclosure includes a glass core (10) and a first redistribution layer (40) disposed on the glass core (10). The first redistribution layer (40) includes a conductive layer (30) and an insulating layer (20) surrounding at least a portion of the conductive layer (30). The first redistribution layer (40) includes an upper surface, and a waviness of the upper surface of the first redistribution layer (40) is 0.7 µm or less. The glass core (10), the first redistribution layer (40), the conductive layer (30), and the insulating layer (20) may be the same as those described above.

### Semiconductor Package

A semiconductor package according to another embodiment of the present specification includes a substrate and a main board (not shown) electrically connected to the substrate.

The substrate may be mounted on the main board and electrically connected to the main board. The main board is not limited as long as it is commonly used in the field of semiconductor devices.

A description regarding the substrate is omitted because it overlaps with the foregoing.

### Method of Manufacturing a Substrate

A method of manufacturing a substrate according to another embodiment of the present disclosure manufactures a substrate by including a preparation step of preparing a base glass plate and a roughening step of preparing a glass core formed by roughening an upper surface of the base glass plate.

In the preparation step, the base glass plate may be processed to prepare a glass core.

The base glass plate may be applicable as long as it is a plate glass material applied as an electronic component. The base glass plate may be, for example, applicable as an alkali borosilicate glass plate, an alkali-free borosilicate glass plate, or an alkali-free alkaline-earth borosilicate glass plate. As commercial products, for example, products manufactured by manufacturers such as Corning, SCHOTT, and AGC may be applied as the base glass plate.

Before performing the roughening step, defects may be formed in a region in which a through via is to be formed in the base glass plate. Specifically, defects may be formed by irradiating a laser to a region in which a through via is to be formed in the base glass plate. In such a case, in the roughening step, while the upper surface of the base glass plate is roughened, a through via may be formed in a region in which the defects are formed.

The through via formed in the roughening step may be the through via described above. The description of the through via is omitted since it is redundant with the foregoing.

When forming the defects, a laser may be irradiated through a laser irradiation device. A focal size applied when forming the defects may be 5 µm to 50 µm. A wavelength of the laser irradiated when forming the defects may be 200 nm to 500 nm. The laser may be irradiated for 5 seconds to 30 seconds when forming the defects. For example, a VYPER model of Coherent Corp. may be applied as the laser irradiation device.

The roughening step may include an ultrasonic treatment process of ultrasonically treating the upper surface of the base glass plate with an acidic solution.

In the ultrasonic treatment process, the upper surface of the base glass plate may be immersed in an acidic solution, and ultrasonic vibration may be applied to the acidic solution. Through this, non-uniform etching by the acidic solution may occur on the upper surface of the base glass plate, thereby providing a glass core having a roughness characteristic and a surface characteristic intended in the present disclosure.

The acidic solution may be one in which an acid component is dissolved using deionized water as a solvent. The acid component may be selected from a group consisting of hydrofluoric acid, nitric acid, hydrochloric acid, sulfuric acid, hydrobromic acid, hydroiodic acid, perchloric acid, chloric acid, and combinations thereof.

The ultrasonic treatment process may be performed by placing the base glass plate in an acidic solution containing hydrofluoric acid and/or nitric acid, and applying ultrasonic treatment thereto. In this case, the concentration of the hydrofluoric acid may be 0.5 M or greater, or may be 1.1 M or greater. The concentration of the hydrofluoric acid may be 3 M or less, or may be 2 M or less. The concentration of the nitric acid may be 0.5 M or greater, or may be 1 M or greater. The concentration of the nitric acid may be 2 M or less.

The ultrasonic treatment process may be performed at a frequency of 40 Hz to 120 Hz, or may be performed at a frequency of 60 Hz to 100 Hz. The ultrasonic treatment process may be performed at an output of 80% or greater, may be performed at an output of 90% or greater, or may be performed at an output of 100%.

The ultrasonic treatment process may be performed for 30 seconds or longer, may be performed for 1 minute or longer, or may be performed for 3 minutes or longer. The ultrasonic treatment process may be performed for 30 minutes or less, may be performed for 20 minutes or less, or may be performed for 10 minutes or less. In this case, the upper surface of the base glass plate may be prevented from being excessively damaged, and may be provided with the roughness characteristics intended in the present disclosure.

The roughening step may further include a rinsing process of rinsing the glass core after completing the ultrasonic treatment process. In the rinsing process, the acidic solution remaining on the surface of the glass core may be removed to suppress excessive surface damage of the glass core. In the rinsing process, the surface of the glass core may be rinsed with ultrapure water.

The roughening step may further include a plasma treatment process of plasma-treating the surface of the glass core after completing the ultrasonic treatment process. The plasma treatment process may be applied to the glass core after completing the rinsing process described above.

In the plasma treatment process, plasma etching may be performed on the upper surface of the glass core roughened by the acidic solution. Through this, while preventing the upper surface of the glass core from becoming excessively rough, fine irregularities having a micro-scale size may be additionally formed on the upper surface, thereby further improving the bonding strength between the insulating layer and the glass core.

In the plasma treatment process, after placing the glass core in a chamber such that the upper surface of the glass core faces upward, a process gas may be introduced into the chamber and discharged to plasma-treat the upper surface of the glass core.

The process gas in the plasma treatment process may comprise oxygen gas. The process gas may further comprise an inert gas. For example, the inert gas may be argon. The process gas in the plasma treatment process may comprise oxygen gas.

In the plasma treatment process, the ambient pressure may be 0.05 Torr or greater. The ambient pressure may be 0.1 Torr or greater. The ambient pressure may be 0.15 Torr or greater. The ambient pressure may be 0.5 Torr or less. The ambient pressure may be 0.3 Torr or less. In this case, a sufficient amount of plasma gas may be smoothly generated in the atmosphere in which the glass core is disposed.

The plasma treatment process may be performed for 30 seconds or longer. The plasma treatment process may be performed for 1 minute or longer. The plasma treatment process may be performed for 2 minutes or longer. The plasma treatment process may be performed for 30 minutes or less. The plasma treatment process may be performed for 20 minutes or less. The plasma treatment process may be performed for 10 minutes or less. In this case, the upper surface of the glass core may help to have roughness characteristics and surface characteristics suitable for laminating an insulating layer.

The roughening step may further include a process of rinsing the glass core after completing the plasma treatment process. The glass core may be dry-rinsed with a gas having low reactivity. For example, the glass core may be rinsed with nitrogen gas.

The roughness characteristics and surface characteristics of the upper surface of the glass core after completing the roughening step may be the same as the roughness characteristics and surface characteristics of the upper surface of the glass core described above. The description of the roughness characteristics and surface characteristics of the upper surface of the glass core after completing the roughening step is omitted since it is redundant with the foregoing.

The method of manufacturing a substrate of the present disclosure may further comprise a step of forming an insulating layer on a glass core after completing a roughening step.

The method of manufacturing a substrate of the present disclosure may further comprise a step of forming an insulating layer on a glass core after completing a roughening step. The method of manufacturing a substrate of the present disclosure may further comprise a step of forming a first conductive layer on the glass core after completing the roughening step, and a step of forming an insulating layer on the glass core on which the first conductive layer is formed.

The first conductive layer may be disposed in contact with the upper surface of the glass core. The glass core and the first conductive layer may be applied as the glass core and the first conductive layer described above.

The first conductive layer may be formed by a dry method or a wet method. The dry method is a method of forming a seed layer by performing sputtering on a region where the first conductive layer is to be disposed, and forming a conductive layer by plating on a region where the seed layer is formed. Metals such as titanium, chromium, or nickel may be sputtered when forming the seed layer, and copper may be sputtered together with the metal. Through sputtering, an anchor effect in which metal particles interact with the surface of the glass core, a crack prevention layer, or an insulating layer may appear, thereby improving adhesion of the conductive layer.

The wet method is a method of performing metal plating after treating a region where the first conductive layer needs to be formed with a primer. The primer may comprise a compound having a functional group such as an amine. Depending on the degree of adhesion intended, the primer may further comprise both a compound having a functional group such as an amine and a silane coupling agent. When applying the silane coupling agent, the surface to be treated with the primer may be pretreated with the silane coupling agent, and a primer layer may be formed by coating a compound having an amine group on the pretreated region.

After forming a seed layer or a primer layer, a first conductive layer may be formed by plating a metal. Although copper plating may be applied when forming the first conductive layer, the present disclosure is not limited thereto. Before metal plating, a region in the seed layer or primer layer where formation of the first conductive layer is unnecessary may be deactivated, or a region where formation of the first conductive layer is necessary may be activated, and then plating may be performed. The activation or deactivation treatment method may comprise photo-irradiation treatment such as irradiating laser light having a specific wavelength, or chemical treatment. However, without applying activation or deactivation treatment, after metal plating is performed, the first conductive layer may be patterned by etching according to a pre-designed shape.

After forming the first conductive layer, an insulating layer surrounding the first conductive layer may be formed.

The insulating layer may be prepared by laminating a film for forming an insulating layer on a base substrate and curing the film, or by coating a composition for forming an insulating layer on a base substrate and curing the composition.

The film for forming the insulating layer may comprise an epoxy resin and a filler. The film for forming the insulating layer may comprise an epoxy resin and a filler before curing.

The film for forming the insulating layer may comprise 10 wt % or more of epoxy resin. The film for forming the insulating layer may comprise 15 wt % or more of epoxy resin. The film for forming the insulating layer may comprise 20 wt % or more of epoxy resin. The film for forming the insulating layer may comprise 35 wt % or less of epoxy resin. The film for forming the insulating layer may comprise 32 wt % or less of epoxy resin. The film for forming the insulating layer may comprise 29 wt % or less of epoxy resin. The film for forming the insulating layer may comprise 25 wt % or less of epoxy resin.

The explanation of the epoxy resin and the filler is omitted because it is redundant with the foregoing description.

The film for forming the insulating layer may further comprise additives that are generally used in the field of build-up films. The additives may include, for example, a curing agent, a colorant, or a defoaming agent.

An insulating layer may be formed by curing a film for forming an insulating layer laminated on the glass core. The film for forming the insulating layer may be disposed in contact with a portion of the upper surface of the glass core. The film for forming the insulating layer may be disposed in contact with the upper surface of the first conductive layer disposed on the glass core.

The curing may proceed through two or more processes including a lamination process and a curing process.

In the lamination process, a vacuum atmosphere may be formed, the film for forming the insulating layer may be disposed on an insulating layer forming region, and the film may be laminated by applying pressure thereto.

The vacuum pressure in the lamination process may be 2 hPa or greater. The vacuum pressure may be 3 hPa or greater. The vacuum pressure may be 10 hPa or less.

The ambient temperature during the lamination process may be 50°C or higher. The ambient temperature may be 60°C or higher. The ambient temperature may be 100°C or lower. The ambient temperature may be 90°C or lower.

The pressure applied during lamination of the film for forming the insulating layer may be 0.2 MPa or higher. The pressure may be 0.3 MPa or higher. The pressure may be 1 MPa or lower.

The time during which pressure is applied when laminating the film for forming the insulating layer may be 10 seconds or more. The time may be 20 seconds or more. The time may be 90 seconds or less. In the lamination process, the laminated film for forming the insulating layer may be further pressed.

When pressing the laminated film for forming the insulating layer, the pressure applied may be 0.2 MPa or higher. The pressure may be 0.3 MPa or higher. The pressure may be 1 MPa or lower.

In the curing process, the laminated film for forming the insulating layer may be cured to form an insulating layer.

The ambient temperature in the curing process may be 120°C or higher. The ambient temperature may be 140°C or higher. The ambient temperature may be 160°C or higher. The ambient temperature may be 250°C or lower.

The curing process may be performed for 10 minutes or longer. The curing process may be performed for 15 minutes or longer. The curing process may be performed for 20 minutes or longer. The curing process may be performed for 60 minutes or shorter.

After forming a second conductive layer on the insulating layer, an insulating layer surrounding an upper side of the second conductive layer may be formed to form a first redistribution layer.

The second conductive layer may be formed by using the same method as that of forming the first conductive layer described above.

The explanation of the first redistribution layer is omitted because it is redundant with the foregoing description.

If necessary, a second redistribution layer may be formed under the base substrate by using the same method as that applied to form the first redistribution layer.

The method of manufacturing a substrate of the present disclosure may further comprise a process of forming connection terminals, bumps, or a cover layer on an upper surface and/or a lower surface of the substrate, and/or a process of mounting an element on the substrate.

A method of manufacturing a substrate according to another embodiment of the present disclosure is a method of manufacturing a substrate including an insulating layer forming process for forming an insulating layer on a glass core on which a first conductive layer is formed on an upper surface.

The glass core may be the same as the glass core described above. The insulating layer forming process may be the same as the step of forming an insulating layer described above.

Hereinafter, specific embodiments will be described in more detail. The following embodiments are merely examples for better understanding of the present invention, and the scope of the present invention is not limited thereto.

### Manufacturing Example: Manufacture of Substrate

Example 1-1: A basic glass plate, which is an alkali glass substrate having a width of 1 cm, a length of 1 cm, and a thickness of 540 µm, was prepared. On the surface of the glass substrate, a laser having a wavelength of 308 nm and a focal size of 30 µm was repeatedly irradiated for 10 seconds by using a laser irradiation apparatus (manufacturer: Coherent Corp. / model name: VYPER) to form defects.

The glass substrate with the formed defects was immersed in an acidic solution. The acidic solution applied was a solution comprising hydrofluoric acid of 2 M and nitric acid of 1.1 M in deionized water. By applying an ultrasonic vibration of 80 Hz frequency and 100 % output to the acidic solution for 5 minutes, the surface of the substrate was etched, and through-vias were formed in the regions of the substrate where defects were generated in the thickness direction of the substrate.

Thereafter, the glass substrate was rinsed with ultrapure water for one minute, and then placed in a chamber with its upper surface facing upward. Oxygen gas was introduced into the chamber, the internal pressure was adjusted to 0.2 Torr, and plasma treatment was performed for 5 minutes under a source power of 100 W. After completing the plasma treatment, nitrogen gas was sprayed onto the surface of the glass core to complete the glass core.

Example 2-1: A base substrate was prepared as follows. On a glass substrate having a thickness of 500 µm, a first seed layer, which is a titanium layer having a thickness of 150 nm, was formed by sputtering, and on the first seed layer, a second seed layer, which is a copper layer having a thickness of 150 nm, was formed by sputtering. On the seed layers for forming a conductive layer, a conductive layer, which is a copper layer having a thickness of 30 µm, was formed through an electroless plating process to complete a first conductive layer. After laminating a dry film on the first conductive layer, the dry film was developed according to the pattern shape to be transferred, and the pattern was transferred onto the first conductive layer through dry etching. Thereafter, the dry film was removed. The ratio of an area of the first conductive layer to an entire area of the upper surface of the glass substrate was adjusted to 70%.

A build-up film, CELLFIL MD200 manufactured by Taiyo Co., was laminated on the base substrate. The build-up film contained 78 wt % of silica, and the average particle diameter of the silica was controlled to 1.5 µm, and the maximum particle diameter of the silica was controlled to 8 µm.

After performing a first curing process by heat-treating the substrate on which the build-up film was laminated at 100°C for 30 minutes, a second curing process was performed by heat-treating the substrate at 180°C for 5 minutes to prepare an insulating layer.

By the same method, five additional conductive layers and insulating layers were sequentially formed on the insulating layer to prepare a first redistribution layer, and three additional conductive layers and insulating layers were formed under the glass substrate to prepare a second redistribution layer.

A polyimide layer having a thickness of 5 µm was laminated on the upper surface of the first redistribution layer, and a solder resist layer having a thickness of 20 µm was formed on the lower surface of the second redistribution layer.

Thereafter, the glass substrate having the solder resist layer and other layers formed thereon was diced to prepare a substrate.

Example 2-2: A substrate was manufactured under the same conditions as in Example 1, except that no solder resist layer was formed.

Comparative Example 1-1: The basic glass plate applied in Example 1-1 was prepared as a substrate.

### Evaluation Example: Measurement of Surface Energy and Contact Angle

The contact angles of the upper surfaces of the glass cores of Example 1-1 and Comparative Example 1-1 with respect to water and diiodomethane were measured using a Mobile Surface Analyzer (manufacturer: KRUSS). The contact angles were measured on the left and right sides of droplets of water and diiodomethane, respectively, and the average value of the measured values was defined as the contact angle of the upper surface of the glass core.

Thereafter, the surface energy of the upper surface of the glass core was calculated from the contact angle.

The measured values and calculated values of Example 1-1 and Comparative Example 1-1 are shown in Table 1 below.

### Evaluation Example: Measurement of Roughness Characteristics

After performing ion blow treatment on the upper surfaces of the glass cores of Example 1-1 and Comparative Example 1-1, Rmax, Ra, and Rq values of the upper surfaces of the glass cores were measured according to ISO 4287:1997 by using an Atomic Force Microscope (AFM) NanoWizard Ultra Speed manufactured by JPK Instruments.

The measured values of Example 1-1 and Comparative Example 1-1 are shown in Table 2 below.

### Evaluation Example: Evaluation of Peel Strength

An insulating layer was formed by laminating and curing a build-up film, ABF GL103, having a thickness of 20 µm, on the upper surfaces of the glass cores of Example 1-1 and Comparative Example 1-1, and the substrates were left to stand for 24 hours.

After standing, the peel strength of the insulating layer with respect to the upper surface of the glass core was measured by a 90° peeling test using a universal testing machine, model Instron 5969, manufactured by Instron Co., equipped with a 500 N load cell. During measurement, the insulating layer was peeled at 90° with respect to the upper surface of the glass core, the peeling speed was set to 10 mm/min, the ambient temperature was set to 23°C, and the ambient humidity was set to 50 RH %.

The measured values of Example 1-1 and Comparative Example 1-1 are shown in Table 2 below.

### Evaluation Example: Evaluation of Shear Strength

An insulating layer was formed by laminating and curing a build-up film, ABF GL103, having a thickness of 20 µm, on the upper surfaces of the glass cores of Example 1-1 and Comparative Example 1-1, and the substrates were left to stand for 24 hours.

After standing, the shear strength of the insulating layer with respect to the upper surface of the glass core was measured using a universal testing machine, model Instron 5969, manufactured by Instron Co., equipped with a 1 kN load cell. During measurement, a load was applied to the insulating layer in the in-plane direction of the substrate at a speed of 5 mm/min, and the maximum load until the insulating layer was separated from the upper surface of the glass core was measured as the shear strength. The ambient temperature was set to 23°C, and the ambient humidity was set to 50 RH %.

The measured values of Example 1-1 and Comparative Example 1-1 are shown in Table 2 below.

### Evaluation Example: Measurement of Waviness

The waviness of the surface of the solder resist in Example 2-1 and the surface of the polyimide layer in Example 2-2 was measured using a surface roughness analyzer, model M300, manufactured by Mahr. During measurement with the surface roughness analyzer, the contact pressure was adjusted to 0.75 mN to 1.0 mN, and the measurement speed was adjusted to 0.1 mm/s to 0.5 mm/s. During waviness measurement, filtering of the surface profile of the measurement target was performed. A Gaussian filter was applied during filtering, and the cut-off length was set to 0.8 mm. The resolution was set to 0.01 µm.

The measured values of Examples 2-1 and 2-2 are shown in Table 3 below.

### Evaluation Example: Measurement of Physical Properties of Insulating Layer

The insulating layers were cut out from the substrates of Examples 2-1 and 2-2 and used as test specimens. The modulus of elasticity of the insulating layer was measured using a universal testing machine. The ambient temperature during measurement of the modulus of elasticity was set to 23°C.

The coefficient of thermal expansion of the insulating layer at 23°C was measured using a dynamic mechanical analysis method.

The measured values of the insulating layer of Example 2-1 are shown in Table 3 below.

### Evaluation Example: Evaluation of Core Layer Damage

The occurrence of cracks in the glass cores of the substrates of Examples 2-1 and 2-2 was observed using an optical microscope. When no cracks occurred, the result was evaluated as "Pass," and when cracks occurred, the result was evaluated as "Fail."

The evaluation results of Examples 2-1 and 2-2 are shown in Table 3 below.

**[Table 1]**

| | Contac t angle with water (°, left) | Contac t angle with water (°, right) | Contact angle with water (°, average ) | Contact angle with diiodomethan e (°, left) | Contact angle with diiodomethan e (°, right) | Contact angle with diiodomethan e (°, average) | R_{W/DI} * | Surface Energy (mN/m ) |
|---|---|---|---|---|---|---|---|---|
| Example 1-1 | 48.1 | 48.9 | 48.5 | 47.9 | 49.2 | 48.55 | 1.00 | 57.05 |
| Comparativ e Example 1-1 | 33.3 | 34.1 | 33.7 | 46.2 | 49.1 | 47.65 | 0.71 | 64.14 |

| | | | | | | | | |
|---|---|---|---|---|---|---|---|---|
| * R_{W/DI} refers to the ratio of a contact angle of the upper surface of the glass core with respect to water to a contact angle of the upper surface of the glass core with respect to diiodomethane. | | | | | | | | |

**[Table 2]**

| | Rmax(nm) | Ra(nm) | Rq(nm) | Peel strength (N/cm²) | Shear strength (N/cm²) |
|---|---|---|---|---|---|
| Example 1-1 | 3.4 | 0.3488 | 0.436 | 37.62 | 58.94 |
| Comparative Example 1-1 | 2.59 | 0.2698 | 0.3368 | 21.47 | 35.78 |

**[Table 3]**

| | Waviness (µm) | Modulus of elasticity (GPa) | Coefficient of thermal expansion (ppm/°C) | Core layer damage |
|---|---|---|---|---|
| Example 2-1 | 0.251 | 6.75 | 14 | Pass |
| Example 2-2 | 0.56 | 3.0 | 45 | Pass |

In Table 2, Example 1-1 showed superior results in terms of peel strength and shear strength compared to Comparative Example 1-1. Such results are believed to be due to the substrate of Example 1-1 exhibiting higher affinity to the insulating layer than that of Comparative Example 1-1, and to the anchor effect occurring between the unevenness located on the substrate surface and the insulating layer.

In Table 3, both Examples 2-1 and 2-2 received "Pass" evaluations in the evaluation of core layer damage. This is believed to support that, when the waviness of the first redistribution layer is controlled within the range defined in the present disclosure, damage to the substrate caused by internal stress can be effectively suppressed.

As described above, although preferred embodiments of the present invention have been explained in detail, the scope of the present invention is not limited thereto, and various modifications and improvements made by those skilled in the art using the basic concept of the present invention defined in the following claims are also included within the scope of the present invention.

### [Description of Reference Numerals]

100: Substrate
10: Glass core
11: Upper surface of glass core
20: Insulating layer
30: Conductive layer
31: First conductive layer
32: Second conductive layer
40: First redistribution layer

## Claims

1. The substrate comprising:
a glass core having an upper surface,
wherein a maximum height roughness (Rmax) value of the upper surface of the glass core is 3 nm to 7 nm, and
a surface energy of the upper surface of the glass core is 50 mN/m to 63 mN/m.

2. The substrate of claim 1,
wherein a ratio of a contact angle of the upper surface of the glass core with respect to water to a contact angle of the upper surface of the glass core with respect to diiodomethane is 0.75 or greater.

3. The substrate of claim 1,
wherein a contact angle of the upper surface of the glass core with respect to water is 40° to 55°.

4. The substrate of claim 1,
wherein an arithmetic average roughness (Ra) value of the upper surface of the glass core is 0.3 nm to 0.5 nm.

5. The substrate of claim 1,
wherein a root-mean-square roughness (Rq) value of the upper surface of the glass core is 0.4 nm to 1 nm.

6. The substrate of claim 1,
further comprising an insulating layer disposed on the glass core,
wherein the insulating layer comprises an epoxy-based resin.

7. The substrate of claim 6,
wherein a peel strength of the insulating layer with respect to the upper surface of the glass core, measured by a 90° peeling test, is 25 N/cm² or greater.

8. The substrate of claim 6,
wherein a shear strength of the insulating layer with respect to the upper surface of the glass core is 40 N/cm² or greater.

9. The substrate of claim 1,
wherein the substrate is for use in semiconductor packaging.

10. The substrate of claim 1,
further comprising a first redistribution layer disposed on the glass core,
wherein the first redistribution layer comprises a conductive layer and an insulating layer surrounding at least a portion of the conductive layer,
wherein the first redistribution layer has an upper surface, and
a waviness of the upper surface of the first redistribution layer is 0.7 µm or less.

11. The substrate of claim 10,
wherein the conductive layer comprises a first conductive layer formed in contact with the upper surface of the glass core, and
a ratio of an area of the upper surface of the glass core occupied by the first conductive layer to an entire area of the upper surface of the glass core is 80 % or less.

12. The substrate of claim 11,
wherein a thickness of the first conductive layer is 10 µm to 50 µm.

13. The substrate of claim 10,
wherein a modulus of elasticity of the insulating layer measured at 23 °C is 8 GPa or less.

14. The substrate of claim 10,
wherein a coefficient of thermal expansion of the insulating layer is 60 ppm/°C or less.

15. The substrate of claim 10,
wherein the insulating layer comprises a filler,
and the insulating layer comprises 65 wt % or more of the filler.

16. The substrate of claim 10,
wherein a ratio of a thickness of the first redistribution layer to a thickness of the glass core is 0.1 to 1.

17. A substrate comprising:
a glass core; and
a first redistribution layer disposed on the glass core,
wherein the first redistribution layer comprises a conductive layer and an insulating layer surrounding at least a portion of the conductive layer,
wherein the first redistribution layer has an upper surface, and
a waviness of the upper surface of the first redistribution layer is 0.7 µm or less.

18. A method of manufacturing a substrate, comprising:
a preparation step of preparing a base glass plate; and
a roughening step of forming a glass core by roughening an upper surface of the base glass plate,
wherein the glass core has an upper surface,
a maximum height roughness (Rmax) value of the upper surface of the glass core is 3 nm to 7 nm, and
a surface energy of the upper surface of the glass core is 50 mN/m to 63 mN/m.
